# EUROPEAN PATENT APPLICATION

(11) **EP 4 687 398 A2**
(43) Date of publication of application: **04.02.2026**
(21) Application number: 25192054.2
(22) Date of filing: 28.07.2025
(51) Int. Cl.: H10D 84/82, H10D 30/66, H10D 84/83, H10D 84/84

(54) **POWER SEMICONDUCTOR DEVICE**

(30) Priority: 01.08.2024 DE 102024207319
(71) Applicant: Infineon Technologies Austria AG, 9500 Villach (AT)
(72) Inventor: MAUDER, Anton, 83059 Kolbermoor (DE); MIATTON, Daniele, 27020 Carbonara al Ticino (IT)
(74) Representative: Infineon Patent Department

(57) **Abstract**

A power semiconductor device includes: a semiconductor substrate; a power transistor formed in a cell field of the semiconductor substrate; a reference terminal; a sense terminal; and a depletion mode sense transistor integrated in the semiconductor substrate and having a voltage tap region of a first conductivity type. The voltage tap region is electrically connected to the sense terminal and follows a drift zone potential of the power transistor until a normally conducting channel of the depletion mode sense transistor pinches off. A pinch-off point of the normally conducting channel of the depletion mode sense transistor is designed such that a voltage between the sense terminal and the reference terminal is clamped below a maximum drain/collector voltage of the power semiconductor device.

## Description

### TECHNICAL FIELD

The present disclosure relates to a power semiconductor device.

### BACKGROUND

Many power semiconductor sensing and control tasks would benefit from the sign of the drain/collector voltage, whether the drain/collector voltage exceeds a certain threshold, and the magnitude of the voltage value at the drain/collector side of the power semiconductor device when the device is in normal conduction in the first (forward direction) quadrant or the third (reverse direction) quadrant. However, for high voltage power transistors designed for hundreds to thousands of volts or more, the full drain/collector voltage exceeds the maximum input voltage of conventional integrated circuits, which requires expensive circumvention such as high voltage decoupling diodes or high voltage devices in IC technologies. For example, desaturation (DESAT) diodes are typically used to detect short circuits or evaluate the sign and value of the load current to determine the quadrant of operation in resonant circuits.

Therefore, there is a need for an integrated sensing technique that enables safe sensing of the drain/collector voltage of power semiconductor devices.

### SUMMARY

According to an embodiment of a power semiconductor device, the power semiconductor device comprises: a semiconductor substrate; a power transistor formed in a cell field of the semiconductor substrate; a reference terminal; a sense terminal; and a depletion mode sense transistor integrated in the semiconductor substrate and having a voltage tap region of a first conductivity type, wherein the voltage tap region is electrically connected to the sense terminal and follows a drift zone potential of the power transistor until a normally conducting channel of the depletion mode sense transistor pinches off, wherein a pinch-off point of the normally conducting channel of the depletion mode sense transistor is designed such that a voltage between the sense terminal and the reference terminal is clamped below a maximum drain/collector voltage of the power semiconductor device.

Those skilled in the art will recognize additional features and advantages upon reading the following detailed description, and upon viewing the accompanying drawings.

### BRIEF DESCRIPTION OF THE DRAWINGS

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
FIG. 1 illustrates a schematic diagram of an embodiment of a power electronics device that includes a power semiconductor device and a corresponding driver IC.
FIG. 2 illustrates a partial cross-sectional view of the power semiconductor device, according to an embodiment.
FIG. 3 illustrates the voltage at a voltage tap region of the depletion mode sense transistor, as a function of the drain voltage of a main power transistor and the finite value of a measurement system evaluating the tap voltage.
FIG. 4 illustrates a partial cross-sectional view of the power semiconductor device, according to another embodiment.
FIG. 5 illustrates a partial cross-sectional view of the power semiconductor device, according to another embodiment.
FIG. 6 illustrates a partial cross-sectional view of the power semiconductor device, according to another embodiment.
FIG. 7 illustrates a partial cross-sectional view of the power semiconductor device, according to another embodiment.
FIG. 8 illustrates a partial cross-sectional view of the power semiconductor device, according to another embodiment.
FIG. 9 illustrates a partial cross-sectional view of the power semiconductor device, according to another embodiment.

### DETAILED DESCRIPTION

Embodiments described herein integrate inside power switch technology a voltage limiting pattern that allows for safe sensing of the drain/collector voltage of a power transistor. The voltage limiting pattern clamps to safe values for the driver circuit connected to the power transistor. The output signal of the voltage limiting pattern can be used by the driver circuit and, in general, in the system, for an improved driving scheme and improved power switch protection.

The voltage limiting pattern is implemented by a depletion mode (normally-on) sense transistor integrated in the same semiconductor substrate as the power transistor. The depletion mode sense transistor includes a voltage tap region that follows the drift zone potential of the power transistor until a normally conducting channel of the depletion mode sense transistor pinches off. The pinch-off point of the normally conducting channel of the depletion mode sense transistor is designed such that the voltage between the sense terminal and a reference terminal (e.g., Kelvin terminal, source/emitter terminal, etc.) is clamped below a maximum drain/collector voltage of the power semiconductor device, allowing safe sensing of the drain/collector voltage using IC technologies which are typically rated for voltages in a range of 5V to 40V, for example.

Described next with reference to the figures are embodiments of the depletion mode sense transistor.

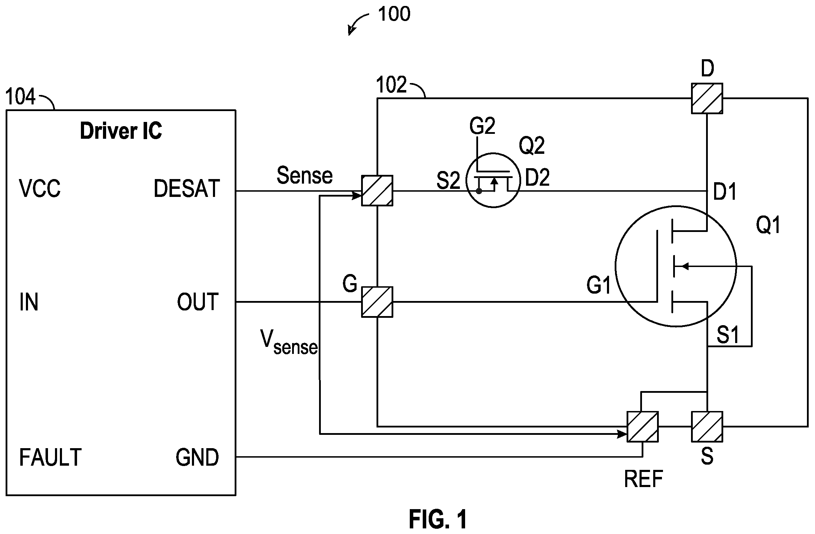

FIG. 1 illustrates a schematic diagram of an embodiment of a power electronics device 100 that includes a power semiconductor device 102 and a corresponding driver IC 104. The power semiconductor device 102 includes a power transistor Q1 that has a maximum voltage rating in a range of 50V to 1200V or higher, depending on the type of power transistor and semiconductor technology used. The power transistor Q1 is formed in a cell field of a semiconductor substrate, which is not shown in FIG. 1. The driver IC 104 drives a gate terminal G of the power semiconductor device 102 and has a maximum voltage rating in a range of 5V to 40V, for example. More generally, the maximum voltage rating of the driver IC 104 is less than the maximum voltage rating of the power transistor Q1 included in the power semiconductor device 102.

The power semiconductor device 102 also includes a reference terminal REF such as a Kelvin terminal or an auxiliary source/emitter terminal, and a sense terminal SENSE. The reference terminal REF of the power semiconductor device 102 may be connected to a ground terminal GND of the driver IC 104, and the sense terminal SENSE of the power semiconductor device 102 may be connected to a corresponding sense input terminal DESAT of the driver IC 104. The driver IC 104 also includes a supply terminal VCC for powering the driver IC 104, and a gate drive input terminal IN for receiving a logic signal such as a PWM (pulse width modulation) signal that indicates how the power transistor Q1 included in the power semiconductor device 102 is to be driven. The driver IC 104 also has a gate drive output terminal OUT for driving the gate terminal G of the power semiconductor device 102, based on the logic signal received at the gate drive input terminal IN.

The driver IC 104 may adjust or terminate driving of the power semiconductor device 102 based on the voltage sensed at the sense input terminal DESAT of the driver IC 104. The driver IC 104 may also include a fault terminal FAULT for indicating an overvoltage or undervoltage condition, based on the voltage level sensed at the sense input terminal DESAT. Since the voltage at the drain/collector terminal D of the power semiconductor device 102 can exceed the maximum rated voltage of the driver IC 104, e.g., by hundreds or even thousands of volts, the power semiconductor device 102 includes a depletion mode sense transistor Q2 integrated in the same semiconductor substrate as the power transistor Q1. The depletion mode sense transistor Q2 is a normally-on device in that the depletion mode sense transistor Q2 is normally on at zero gate-source voltage.

The depletion mode sense transistor Q2 is schematically illustrated in FIG. 1 with a drain/collector D2 electrically connected to the drain/collector D1 of the power transistor Q1, a source/emitter S2 electrically connected to the sense terminal SENSE terminal of the power semiconductor device 102, and a gate G2. The drain/collector D1 of the power transistor Q1 is electrically connected to the drain/collector terminal D of the power semiconductor device 102, the gate G1 of the power transistor Q1 is electrically connected to the gate terminal G of the power semiconductor device 102, and the source/emitter S1 of the power transistor Q1 is electrically connected to both the source/emitter terminal S of the power semiconductor device 102 and the reference terminal REF of the power semiconductor device 102.

The depletion mode sense transistor Q2 integrated in the same semiconductor substrate as the power transistor Q1 has a voltage tap region which is not shown in FIG. 1. The voltage tap region of the depletion mode sense transistor Q2 is electrically connected to the sense terminal SENSE of the power semiconductor device 102 and follows the drift zone potential of the power transistor Q1 until a normally conducting channel of the depletion mode sense transistor Q2 pinches off. The pinch-off point of the normally conducting channel of the depletion mode sense transistor Q2 is designed such that the voltage V_{SENSE} between the sense terminal SENSE and the reference terminal REF of the power semiconductor device 102 is clamped below the maximum drain/collector voltage of the power semiconductor device 102. For example, the pinch-off point of the normally conducting channel of the depletion mode sense transistor Q2 may be designed such that V_{SENSE} remains below the maximum rated voltage of the driver IC 104. In one embodiment, the pinch-off point of the normally conducting channel of the depletion mode sense transistor Q2 is designed such that the voltage between the sense terminal SENSE and the reference terminal REF of the power semiconductor device 102 is clamped in a range of 5V to 40V.

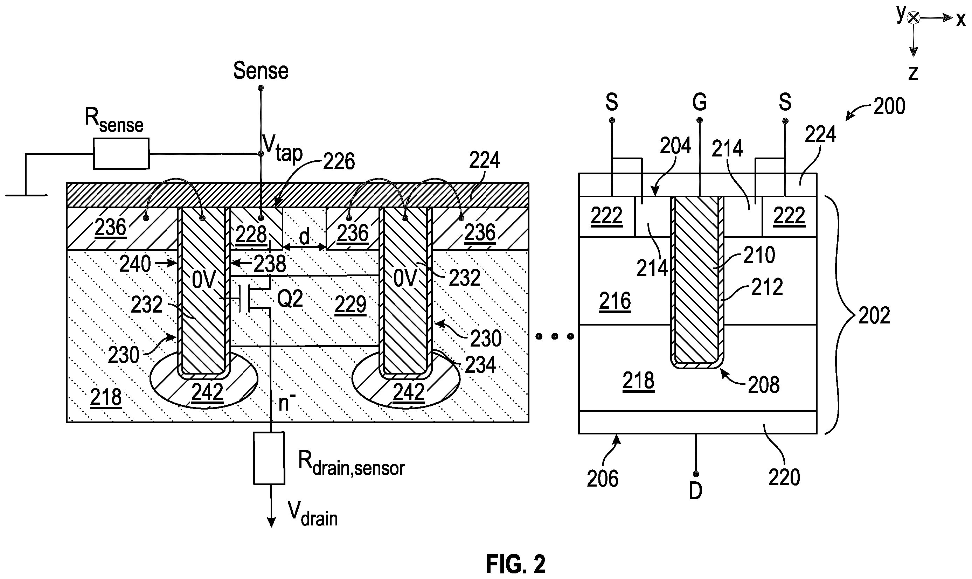

FIG. 2 illustrates a partial cross-sectional view of the power semiconductor device 102, according to an embodiment. As explained above in connection with FIG. 1, the power transistor Q1 is formed in a cell field 200 of a semiconductor substrate 202 and the depletion mode sense transistor Q2 is integrated in the same semiconductor substrate 202 as the power transistor Q1. The semiconductor substrate 202 comprises one or more semiconductor materials used to form the power semiconductor device 102. For example, the semiconductor substrate 202 may comprise Si, silicon carbide (SiC), germanium (Ge), silicon germanium (SiGe), gallium nitride (GaN), gallium arsenide (GaAs), and the like. The semiconductor substrate 202 may include one or more epitaxial layers.

The cell field 200 is surrounded by an edge termination structure formed in the semiconductor substrate 202, which is not shown in FIG. 2. The cell field 200 includes the cells of the power transistor Q1 that collectively handle the load current of the power semiconductor device 102. The power transistor cells are electrically coupled in parallel to form the power transistor Q1 such as a power MOSFET (metal-oxide-semiconductor field-effect transistor), a superjunction power MOSFET having charge balancing structures such as alternating n-type and p-type columns, an IGBT (insulated gate bipolar transistor) having MOS power transistor cells), a JFET (junction FET), a HEMT (high electron mobility transistor), etc. In general, the power semiconductor device 100 may have tens, hundreds, thousands, or even more power transistors cells. One such power transistor cell is shown in FIG. 2.

In FIG. 2, the power transistor Q1 is a vertical device in that the main load current of the power semiconductor device 102 flows between first and second main surfaces 204, 206 of the semiconductor substrate 202. The power transistor cell shown in FIG. 2 includes a gate trench 208 that extends in a vertical direction (z direction in FIG. 2) from the first main surface 206 into the semiconductor substrate 202. The gate trench 208 may be stripe-shaped, for example. The term 'stripe-shape' as used herein means a structure having a longest linear dimension in a direction (y direction in FIG 2) generally perpendicular to the depth-wise direction (z direction in FIG. 2) of the semiconductor substrate. The gate trench 208 instead may have another shape, e.g., such as spicular, columnar, etc.

The gate trench 208 includes a gate electrode 210 and at least one dielectric material 212 (such as a single dielectric material or a material stack) separating the gate electrode 210 from the semiconductor substrate 202. In the case of Si technology, the gate trench 208 may also include an optional field electrode (not shown in FIG. 2) below the gate electrode 210. In the case of SiC technology, a shielding region (not shown in FIG. 2) may be formed at or below the bottom of the gate trench 208. A source region 214 of a first conductivity type and a body region 216 of a second conductivity type opposite the first conductivity type adjoin at least one sidewall of the gate trench 208. The source region 214 of each power transistor cell is separated from a (common) drift zone 218 of the first conductivity type by the corresponding body region 216. In the case of a vertical power transistor, a drain/collector region 220 is disposed at the backside 206 of the semiconductor substrate 202, as shown in FIG. 2. In the case of a lateral power transistor where the main load current of the power semiconductor device 102 flows along the first main surface 204 of the semiconductor substrate 202, the drain/collector region 220 would be disposed at the frontside 204 of the semiconductor substrate 202.

The first conductivity type is n-type and the second conductivity type is p-type for an n-channel device formed by the power transistor cells, whereas the first conductivity is p-type and the second conductivity type is n-type for a p-channel device formed by the power transistor cells. For either an n-channel device or a p-channel device, the source region 214 and the body region 216 form part of a transistor cell and the transistor cells are electrically connected in parallel between the source and drain terminals S, D of the power semiconductor device 102 to form the power transistor Q1.

The body regions 216 of the power transistor cells may include a body contact region 222 of the second conductivity type. The body contact regions 222 have a higher doping concentration than the body regions 216, to provide an ohmic connection with a source / emitter metallization (not shown in FIG. 2) through a contact structure (not shown in FIG. 2) such as electrically conductive vias that extend through an interlayer dielectric 224 that separates the source metallization from the semiconductor substrate 202. The source regions 214 of the power transistor cells are also electrically connected to the source metallization through the contact structure.

The gate electrodes 210 are electrically connected to the gate terminal G of the power semiconductor device 102 through, e.g., a gate metallization which is not shown in FIG. 2. The gate metallization may be part of a structured power metallization that also includes the source metallization. Such a structured power metallization may include a thick power metal layer that comprises Cu, Al, AlCu, AlSiCu, etc., a diffusion barrier and/or adhesion promoter such as Ti and/or TiN and/or W between the thick power metal layer and the interlayer dielectric 224. A drain metallization (not shown in FIG. 2) may be provided at the opposite side of the semiconductor substrate 202 as the source metallization.

The power transistor Q1 may have a different cell configuration than what is shown in FIG. 2. For example, the power transistor Q1 may have a planar gate configuration where the gate electrodes are formed on and insulated from the first main surface 204 of the semiconductor substrate 202. The transistor cells instead may be JFET or HEMT cells. In the case of an IGBT as the power transistor Q1, MOS cells are used in conjunction with p-doped regions at the back side to provide carrier flooding. The depletion mode sense transistor Q2 may be used with any of these power transistor cell configurations and other power transistor cell configurations, to limit voltage sensing to safe values for the driver IC 104 connected to the power semiconductor device 102.

As explained above in connection with FIG. 1, the depletion mode sense transistor Q2 has a voltage tap region 226 of the first conductivity type, i.e., the same conductivity type as the drift, source, and drain regions 218, 214, 220 of the main power transistor Q1. The voltage tap region 226 of the depletion mode sense transistor Q2 adjoins the drift zone 218 of the first conductivity type shared with the power transistor Q1 or is part of the drift zone 218. In FIG. 2, the voltage tap region 226 of the depletion mode sense transistor Q2 includes a highly doped region 228 of the first conductivity type that has a higher average doping concentration than the drift zone. For example, the highly doped voltage tap region 228 may be an n+ doped region for an n-channel device or a p+ doped region for a p-channel device. The highly doped region 228 may be omitted and the voltage tap region 226 of the depletion mode sense transistor Q2 instead may be formed by just part of the drift zone 218.

In each case, the voltage tap region 226 of the depletion mode sense transistor Q2 follows the drift zone potential of the power transistor Q1 until a normally conducting channel of the depletion mode sense transistor Q2 pinches off. The pinch-off point is designed such that the voltage V_{SENSE} between the sense terminal SENSE and the reference terminal REF of the power semiconductor device 102 is clamped below the maximum drain/collector voltage V_{Drain_Max} of the power semiconductor device 102.

The backside 206 of the semiconductor substrate 202 may reach voltages of several 100V to several kV (e.g., 1200V, 2000V, 3300V, or higher). The potentials in the active device area at the frontside 204 of the semiconductor substrate 202 typically differ by small voltages from the voltage of the source electrode (e.g. in a range of -5 to +25V) while the major part of the blocking voltage drops across the drift zone 218 which may be doped n-.

At low absolute values of the drain voltage V_{Drain} (e.g., during on-state of the channel or during conduction of the body diode), the voltage Vₜₐₚ at the voltage tap region 226 of the depletion mode sense transistor Q2 follows 1:1 the potential in the upper part of the drift zone 218. During body diode operation (i.e., third quadrant operation), the voltage Vₜₐₚ at the voltage tap region 226 of the depletion mode sense transistor Q2 is limited by the diffusion voltage of the pn-junction (e.g., approximately 2.7V for SiC) plus eventually a small ohmic voltage drop due to the load current. Accordingly, no special action or circuitry is needed to directly feed the voltage Vₜₐₚ at the voltage tap region 226 of the depletion mode sense transistor Q2 to the sense input DESAT of the driver IC 104 via the sense terminal SENSE of the power semiconductor device 102.

During operation of the power transistor Q1 in the first (forward direction) quadrant, when the channel is turned-on, only a small voltage drop across the channel plus eventually a small ohmic voltage drop due to the load current occurs at the voltage tap region 226 of the depletion mode sense transistor Q2. This voltage is measurable by the driver IC 104 or other external circuit at the sense terminal SENSE of the power semiconductor device 100. As the voltage in the drift zone 218 below the depletion mode sense transistor Q2 becomes more positive, the vertical depletion MOSFET formed by gate trenches 230 in FIG. 2 begins to limit the voltage at the voltage tap region 226. Depending on the design (e.g., distance of the electrodes, doping of the base material, etc.), the clamp voltage level V_{clamp} can be adjusted accordingly.

As explained above, the voltage tap region 226 of the depletion mode sense transistor Q2 may adjoin the drift zone 218 of the first conductivity type shared with the power transistor Q1 or may be part of the drift zone 218. In FIG. 2, the voltage tap region 226 of the depletion mode sense transistor Q2 includes a highly doped region 228 of the first conductivity type that has a higher average doping concentration than the drift zone 218 and forms an ohmic contact. Separately or in combination, the depletion mode sense transistor Q2 may include a more highly doped region 229 of the first conductivity type (e.g., n+ or p+, depending on the channel type) which is formed in a part of the drift zone 218 between adjacent gate trenches 230 of the depletion mode sense transistor Q2 to reduce dependence of the maximum tap voltage from doping variations of the drift zone, if desired. This may be done e. g. by means of ion implantation and subsequent annealing to adjust the threshold voltage of the normally conducting channel of the depletion mode sense transistor Q2. The gate electrodes 232 of the depletion mode sense transistor Q2 are disposed in the gate trenches 230 and separated from the semiconductor substrate 202 by at least one dielectric material 234 which may be the same gate dielectric material or material stack used in the cells of the main power transistor Q1.

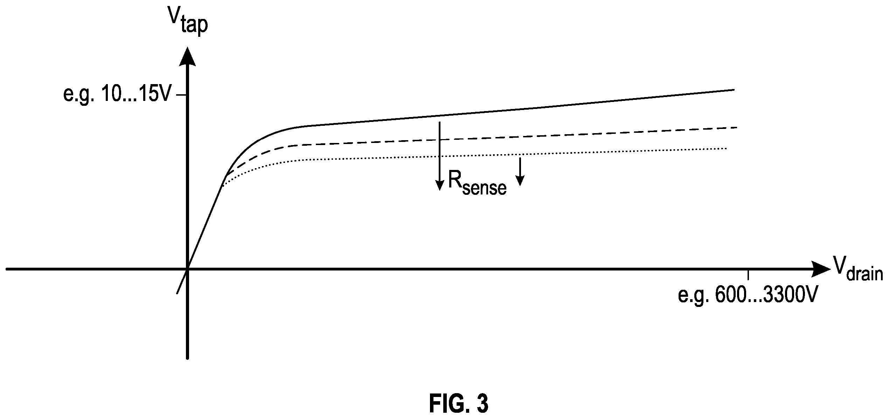

During high voltage blocking, an electrically insulating space charge region spans in the drift zone 218 and therefore, at high voltages, the depletion mode sense transistor Q2 acts more as a current source with a clamping voltage defined by the threshold voltage of the depletion mode sense transistor Q2. Since there will be a finite value of the measurement system evaluating the tap voltage Vₜₐₚ, represented by the high ohmic equivalent resistor R_{Sense} in FIG. 2, the actual voltage Vₜₐₚ at the voltage tap region 226 of the depletion mode sense transistor Q2 depends on the value of R_{Sense} as exemplarily shown in FIG. 3. FIG. 3 illustrates the voltage Vₜₐₚ at the voltage tap region 226 of the depletion mode sense transistor Q2, as a function of the drain voltage V_{Drain} of the main power transistor Q1 and R_{Sense}. The resistance of the drain/collector region of the depletion mode sense transistor Q2 is indicated by the resistor symbol labeled R_{Drain,sensor} in FIG. 2.

During blocking of the main power transistor Q1, electron-hole-pairs are generated inside the space charge regions as thermal generation and/or due to (unwanted) crystal defects leading to leakage current. While the electrons can leave the semiconductor substrate 202 via the n+ drain/collector connection without a barrier, a highly doped region 228 of the first conductivity type for ohmic contact of the voltage tap region 226 of the depletion mode sense transistor Q2 represents a barrier for the small portion of generated holes reaching the sensor signal pattern and not being drained via the p-body-regions 216 of the main power transistor Q1. Therefore, inside the structure of the depletion mode sense transistor Q2, additional highly doped contact regions 236 of the second conductivity may be provided to drain p-leakage current either to the source terminal S of the power semiconductor device 102, e.g., as shown in FIG. 2, or to the sense terminal SENSE of the power semiconductor device 102. The highly doped regions 236 of the second conductivity type may be p+ doped regions for an n-channel device or n+ doped regions for a p-channel device. In case of connecting the highly doped contact regions 236 of the second conductivity to the source terminal S of the power semiconductor device 102, a spacing d is maintained between the highly doped contact regions 228, 236 of the opposite conductivity type to support the voltage Vₜₐₚ at the voltage tap region 226 of the depletion mode sense transistor Q2.

In FIG. 2, both the main power transistor Q1 and the depletion mode sense transistor Q2 are vertical devices. According to this embodiment, each gate trench 230 of the depletion mode sense transistor Q2 extends from the first main surface 204 of the semiconductor substrate 202 into the semiconductor substrate 202 and the voltage tap region 226 adjoins a first sidewall 238 of at least one of the gate trenches 230 at an upper part of the gate trench 230. As explained above, a doped region 236 of the second conductivity type may adjoin a second sidewall 240 of the gate trench 230 of the depletion mode sense transistor Q2 opposite the first sidewall 238 at the upper part of the gate trench 230. The doped region 236 of the second conductivity type may be electrically connected to the source/emitter potential of the power transistor Q1.

The gate electrode 232 in each gate trench 230 of the depletion mode sense transistor Q2 may be electrically connected to the source/emitter potential of the power transistor Q1, as indicated by the corresponding '0V' label in FIG. 2. In the case of SiC as the substrate material and to avoid excessive electric fields at the bottom of the gate trenches 230 of the depletion mode sense transistor Q2, a shielding region 242 of the second conductivity type may adjoin the bottom of each gate trench 230 of the depletion mode sense transistor Q2. The main power transistor Q1 may utilize the same or similar type of shielding region at the bottom of the gate trenches 208 of the power transistor cells.

According to the embodiment illustrated in FIG. 2, the depletion mode sense transistor Q2 is formed in the cell field that includes the transistor cells that form the main power transistor Q1. According to this embodiment, all doping regions and structural elements of the depletion mode sense transistor Q2 are also available in the main power transistor Q1 in FIG. 2, merely with different functionality and/or layout. In this case, the depletion mode sense transistor Q2 can be implemented by simply changing the mask design and at no additional process cost.

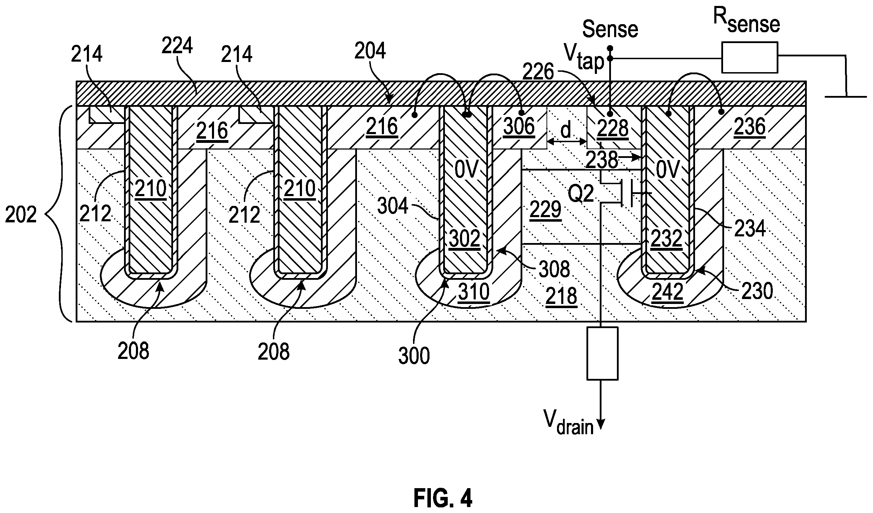

FIG. 4 illustrates a partial cross-sectional view of the power semiconductor device 102, according to another embodiment. In FIG. 4, the substrate material is SiC and the shielding region 242 that adjoins the bottom of each gate trench 230 of the depletion mode sense transistor Q2 extends along the second sidewall 240 of each gate trench 230 to the doped region 236 of the second conductivity type at the upper part of the gate trench 230. The cells of the main power transistor Q1 may have the same or similar shielding region configuration as the depletion mode sense transistor Q2, e.g., as shown in FIG. 4.

Independent of the shielding region configuration, an optional shielding trench 300 may extend from the first main surface of the semiconductor substrate 202 into the semiconductor substrate 202. In FIG. 4, the shielding trench 300 is laterally interposed between a gate trench 230 of the depletion mode sense transistor Q2 and the neighboring gate trench 208 of the power transistor Q1. An electrode 302 in the shielding trench 300 may be electrically connected to the source/emitter potential of the power transistor Q1, as indicated by the corresponding '0V' label in FIG. 4. The shielding trench electrode 302 is separated from the semiconductor substrate 202 by at least one dielectric material 304 which may be the same gate dielectric material or material stack used in the cells of the main power transistor Q1 and/or in the cell(s) of the depletion mode sense transistor Q2.

A doped region 306 of the second conductivity type may adjoin a first sidewall 308 of the shielding trench 300 at an upper part of the shielding trench 300, where the first sidewall 308 of the shielding trench 300 and the first sidewall 238 of the gate trench 230 of the depletion mode sense transistor Q2 face one another. The doped region 306 of the second conductivity type that adjoins the first sidewall 308 of the shielding trench 300 may be a p+ doped region for an n-channel device or an n+ doped region for a p-channel device. The doped region 306 of the second conductivity type that adjoins the first sidewall 308 of the shielding trench 300 may be electrically connected to the source/emitter potential of the power transistor Q1, as indicated by the corresponding '0V' label in FIG. 4 and may be forming a shielding structure similar to the power transistor Q1 and/or the depletion mode sense transistor Q2. According to another example, the gate trench 230 of the depletion mode sense transistor Q2 may be neighboring the shielding region of a cell of the main transistor Q1.

The voltage tap region 226 of the depletion mode sense transistor Q2 and the doped region 306 of the second conductivity type that adjoins the upper part of the first sidewall 308 of the shielding trench 300 are laterally spaced apart from one another by part of the drift zone 218, which is represented by distance 'd' in FIG. 4. A shielding region 310 of the second conductivity type may adjoin the bottom of the shielding trench 300. The shielding region 310 may extend along the first sidewall 308 of the shielding trench 300 to the doped region 306 of the second conductivity type that adjoins the upper part of the first sidewall 308 of the shielding trench 300. Similar to what is shown and described in connection with FIG. 2, at least a part of the drift zone 218 located laterally between a gate trench 230 of the depletion mode sense transistor Q2 and the neighboring shielding region 310 of a cell of the main transistor Q1 or a neighboring shielding trench 300 may include a more highly doped region 229 of the first conductivity type (e.g., n+ or p+, depending on the channel type) compared to the rest of the drift zone 218 outside the gate area (e.g. by means of ion implantation and subsequent annealing), to adjust the threshold voltage of the normally conducting channel of the depletion mode sense transistor Q2. The lateral distance between the gate trench 230 of the depletion mode sense transistor Q2 and the neighboring shielding region of a cell of the main transistor Q1 or the shielding trench 300 may have the same or a different width compared to the lateral distance between the gate trench 208 of a cell of the main transistor Q1 and the neighboring shielding region, to adjust the threshold voltage of the depletion mode sense transistor Q2.

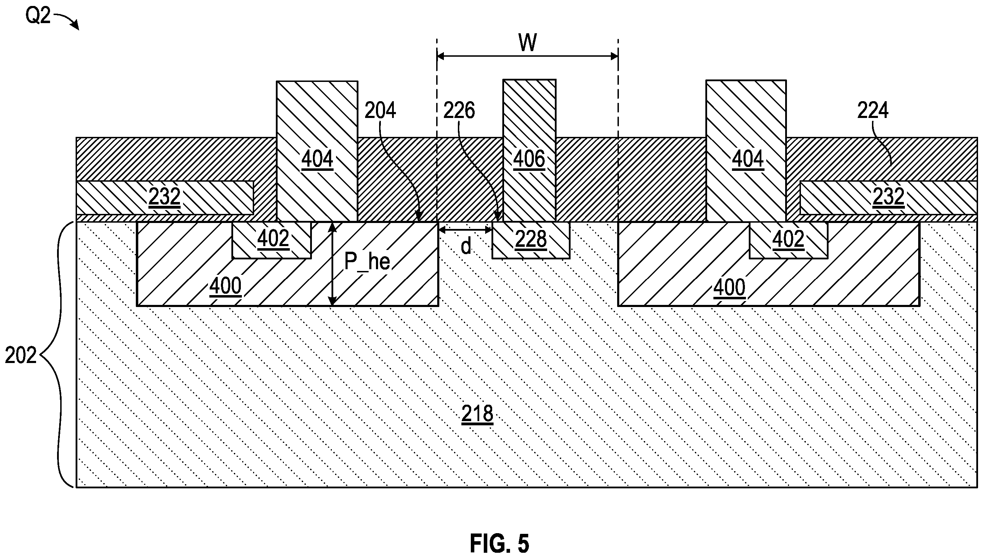

FIG. 5 illustrates a partial cross-sectional view of the power semiconductor device 100, according to another embodiment. In FIG. 5, the gate electrode 232 of the depletion mode sense transistor Q2 is disposed above and electrically insulated from the first main surface 204 of the semiconductor substrate 202. According to this embodiment, the depletion mode sense transistor Q2 is a planar device instead of a trench device. The main power transistor Q1 may also be a planar device, for example.

In FIG. 5, a doped body region 400 of the second conductivity type extends under each gate electrode 232 of the depletion mode sense transistor Q2 and a source/emitter region 402 of the first conductivity type is formed in the doped body region 400 of the second conductivity type. The highly doped voltage tap region 228 is laterally spaced apart from each doped body region 400 of the depletion mode sense transistor Q2, by part of the drift zone 218 which is represented by distance 'd' in FIG. 4. Each doped body region 400 of the depletion mode sense transistor Q2 may be electrically connected to the source/emitter potential of the power transistor Q1.

The lateral distance 'd' shown in FIG. 5 limits the maximum voltage V_{tap_max} which can be measured at the voltage tap region 226 of the depletion mode sense transistor Q2, since when building up both a blocking voltage and lateral space charge regions from the doped body regions 400, the voltage Vₜₐₚ at the voltage tap region 226 can increase beyond the lateral punch through voltage. To avoid a negative effect on the overall blocking behavior of the main power transistor Q1, sufficient shielding of the voltage tap region 226 is provided. In one embodiment, the voltage tap region 226 is adequately shielded by ensuring that the lateral spacing 'W' between adjacent ones of the doped body regions 400 of the depletion mode sense transistor Q2 is smaller than the vertical thickness (P_he) of each doped body region 400.

In FIG. 5, the lateral spacing 'W' between adjacent ones of the doped body regions 400 of the depletion mode sense transistor Q2 equals 2*d plus the width of the highly doped voltage tap region 228. FIG. 5 also shows an emitter/source electrode connections 404 to the doped body and source/emitter regions 400, 402 of the depletion mode sense transistor Q2, and a sense electrode connection 406 to the voltage tap region 226 of the depletion mode sense transistor Q2.

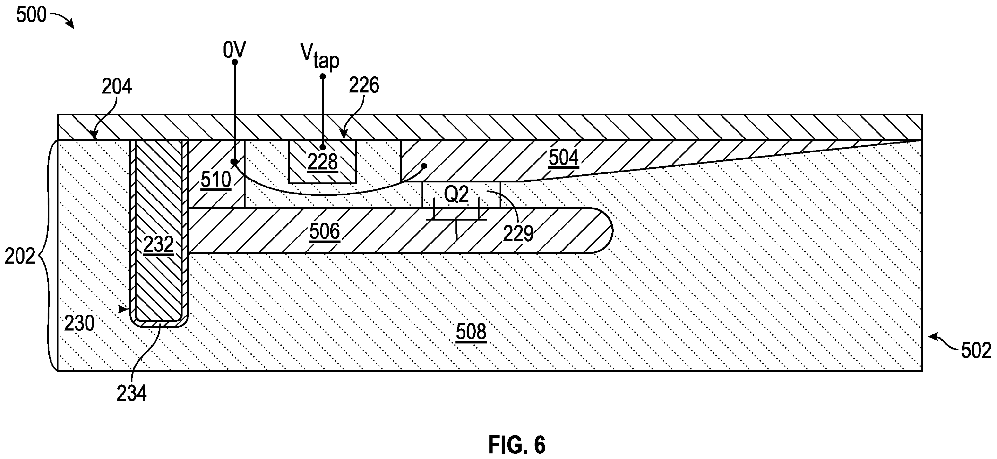

FIG. 6 illustrates a partial cross-sectional view of the power semiconductor device 100, according to another embodiment. In FIG. 6, the depletion mode sense transistor Q2 is formed in an edge termination region 500 of the semiconductor substrate 202 that separates the cell field from the physical edge 502 of the semiconductor substrate 202. In one embodiment, the depletion mode sense transistor Q2 includes an upper gate region 504 of the second conductivity type and a lower gate region 506 of the second conductivity type. For example, the upper gate region 504 of the second conductivity type may be part of a junction termination extension (JTE) doping or part of a region of an area variation of lateral doping (VLD) included in the edge termination region 500.

The upper and lower gate regions 504, 506 of the depletion mode sense transistor Q2 are vertically separated from one another by a layer 508 of the first conductivity type which includes the normally conducting channel of the depletion mode sense transistor Q2. The layer 508 of the first conductivity type may be an n- epitaxial layer for an n-channel device or a p- epitaxial layer for an p-channel device. Similar to what is shown and described in connection with FIGs. 2 and 4, at least a part of the layer 508 of the first conductivity type located vertically between the upper and lower gate regions 504, 506 of the depletion mode sense transistor Q2 may include a more highly doped region 229 of the first conductivity type (e.g., n+ or p+, depending on the channel type) compared to the rest of the layer 508 outside the gate area (e.g. by means of ion implantation and subsequent annealing), to adjust the threshold voltage of the normally conducting channel of the depletion mode sense transistor Q2.

The voltage tap region 226 of the depletion mode sense transistor Q2 adjoins or is part of the layer 508 of the first conductivity type. For example, the voltage tap region 226 may be an upper part of the layer 508 of the first conductivity type or as shown in FIG. 6, the voltage tap region 226 may be a more highly doped region 228 of the first conductivity type (e.g., n+ for an n-channel device or p+ for a p-channel device) formed in the layer 508 of the first conductivity type.

A doped region 510 of the second conductivity type may vertically extend to or form a contact to the lower gate region 506 of the depletion mode sense transistor Q2. The doped region 510 of the second conductivity type may be a p+ doped region for an n-channel device or an n+ doped region for a p-channel device. The doped region 510 of the second conductivity type may be electrically connected to the source/emitter potential of the power transistor Q1, as indicated by the corresponding '0V' label in FIG. 6. The voltage tap region 226 of the depletion mode sense transistor Q2 is laterally spaced apart from the doped region 510 of the second conductivity type by part of the layer 508 of the first conductivity type.

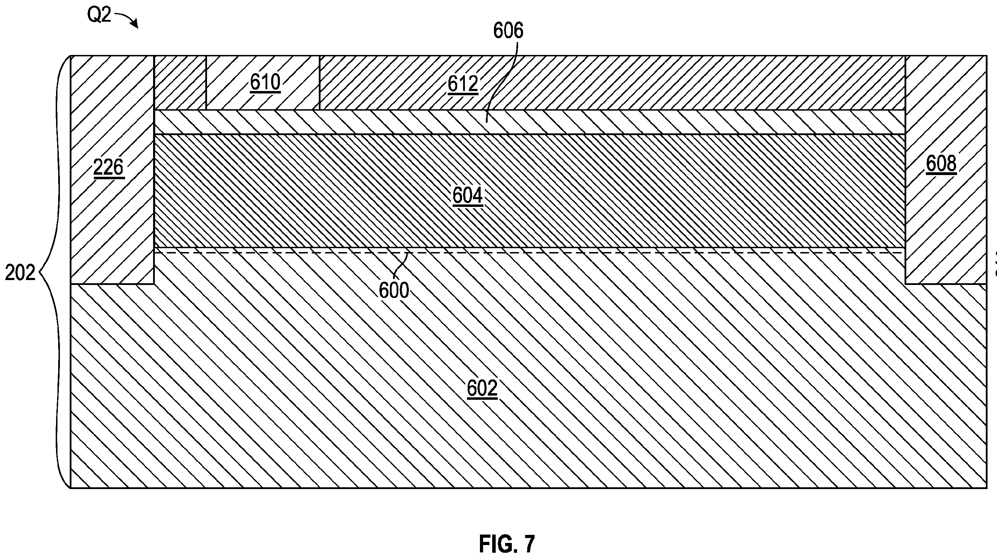

FIG. 7 illustrates a partial cross-sectional view of the power semiconductor device 100, according to another embodiment. In FIG. 7, the depletion mode sense transistor Q2 is a depletion mode HEMT. According to this embodiment, the normally conducting channel of the depletion mode sense transistor Q2 comprises a two-dimensional electron or hole gas 600 in a heterojunction structure of the semiconductor substrate 202. The heterojunction structure may include, e.g., include a p-GaN 602, AlGaN 604 on the p-GaN 602, and a GaN cap 606 on the AlGaN 604.

The two-dimensional electron or hole gas 600 is uninterrupted between a drain/collector region 608 of the depletion mode HEMT and the voltage tap region 226, absent a negative voltage applied between a gate 610 of the depletion mode HEMT and the voltage tap region 226. The gate 610 may be disposed in a dielectric material 612, e.g., such as silicon nitride that covers the cap 606 of the heterojunction structure. The cells of the main power transistor Q1 may have the same or similar depletion mode HEMT configuration as the cell(s) of the depletion mode sense transistor Q2. Alternatively, the cells of the main power transistor Q1 may have an enhancement mode (normally off) HEMT configuration, e.g., by implementing a different gate design than the depletion mode sense transistor Q2. For example, the gates of the power transistor cells may include a p-GaN material that is recessed to a depth near the two-dimensional electron or hole gas 600, to interrupt the two-dimensional electron or hole gas 600 absent a positive gate voltage.

As explained above in connection with the embodiments illustrated in FIGs. 4 and 5, the voltage tap region 226 of the depletion mode sense transistor Q2 may be laterally separated from the neighboring region of the second conductivity type (e.g., doped region 306 for the trench gate embodiment illustrated in FIG. 4 and body region 400 for the planar gate embodiment illustrated in FIG. 5) by part of the drift zone 218, represented by distance 'd' in FIGs. 4 and 5. In other embodiments, the lateral spacing d is reduced to d=0 to provide additional voltage blocking and limiting functionality as described in more detail below.

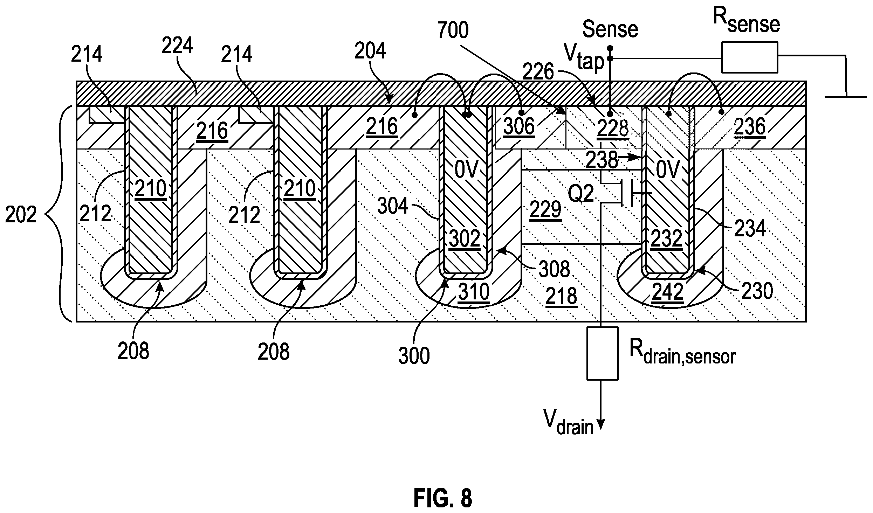

FIG. 8 illustrates an alternative trench gate embodiment, according to which the lateral spacing between the voltage tap region 226 of the depletion mode sense transistor Q2 and the doped region 306 of the second conductivity type that adjoins the upper part of the first sidewall 308 of the neighboring shielding trench 300 is eliminated, at least in part of the depletion mode sense transistor Q2. According to this embodiment, the highly doped region 228 of the first conductivity type and the highly doped region 306 of the second conductivity type contact one another, i.e., form a union or junction of regions yielding a highly doped n+p+ junction 700 at the frontside of the semiconductor substrate 202, the n+p+ junction 700 comprising a p+ doped region (region 306) and an n+ doped region (228). The n+p+ junction 700 may be present in only part of the depletion mode sense transistor Q2 while in other parts, there is still a lateral spacing / distance d>0 available, which could be different, e.g. in areas where the highly doped region 228 of the voltage tap region 226 is contacted to the outside.

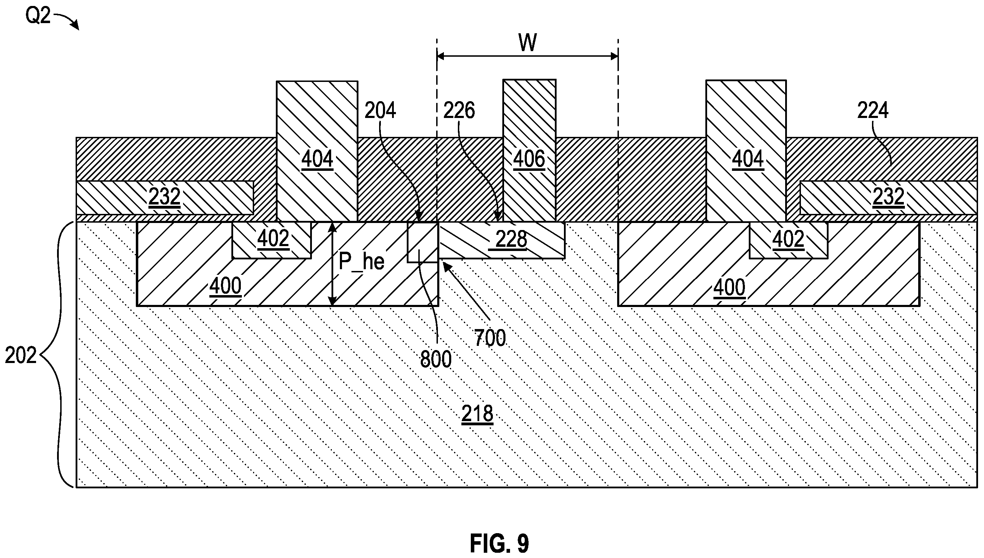

FIG. 9 illustrates an alternative planar gate embodiment, according to which the lateral spacing between the highly doped voltage tap region 228 and each doped body region 400 of the depletion mode sense transistor Q2 is eliminated. According to this embodiment, the highly doped voltage tap region 228 contacts at least locally one doped body region 400 or both doped body regions 400 of the depletion mode sense transistor Q2 to form a union or junction of regions that yields the n+p+ junction 700 at the frontside of the semiconductor substrate 202, the n+p+ junction 700 comprising a p-doped region (region 400) and a highly n+ doped region (228). For example, in FIG. 9, the highly doped voltage tap region 228 contacts the lefthand doped body region 400 but not the righthand doped body region 400. Each doped body region 400 contacted by the highly doped voltage tap region 228 may include a more highly doped (e.g., p+) region 800 in the area where the doped body region 400 abuts the highly doped voltage tap region 228, e.g., similar to how highly doped body contact regions 222 are formed in body regions 216 of power transistor Q1 in FIG. 2.

In FIG. 8 and FIG. 9, making d=0 yields a Zener-like voltage limiting device 700, also referred to herein as n+p+ junction, that blocks sufficient voltage, e.g., in the range of the positive gate voltage and also limits the voltage at the voltage tap region 226 of the depletion mode sense transistor Q2, thus restricting the voltage V_{SENSE} at the sense terminal SENSE of the power semiconductor device 102 to a safe level. For wide band gap semiconductors such as SiC, even though high doping (e.g., p+) is present in the voltage tap region 226 of the depletion mode sense transistor Q2, the blocking voltage of the n+p+ junction 700 is high enough to sustain typical voltage ranges of 15V, 20V, etc. The n+p+ junction 700 also limits the voltage at the voltage tap region 226 and ultimately at the sensor element, thus protecting the low-voltage driver IC 104. Preferably, the blocking voltage of the n+p+ junction 700 is in the range of the gate voltage, but could be somewhat lower or higher, e.g., 15V to 20V or even up to 30V to 40V may be sufficient. The blocking voltage of the n+p+ junction 700 depends on several factors, including the doping design. In each case, the n+p+ junction 700 limits the voltage V_{SENSE} between the sense terminal SENSE and the reference terminal REF of the power semiconductor device 102 to a safe level, even in the case of a defective depletion mode sense transistor Q2.

For example, without the n+p+ junction 700 and if a defect rendered the depletion mode sense transistor Q2 faulty (e.g., weak or no pinch-off), the drain voltage could reach up to the frontside of the semiconductor substrate 202, leading to an unsafe voltage at the voltage tap region 226 tap (e.g., 1200V or more) with a low voltage connection at the source, which can result in flashover and destruction at the device front side. If the depletion mode sense transistor Q2 pinches off at a safe voltage, this is not a concern. However, if the depletion mode sense transistor Q2 is defective or fails, the n+p+ junction 700 provides additional voltage limiting functionality.

The voltage limiting functionality provided by the n+p+ junction 700 in combination with a sufficiently high series resistance yields an even more robust protection feature. A resistive or current limiting path is present from the cell(s) of the depletion mode sense transistor Q2 to the backside of the semiconductor substrate 202, resulting in an equivalent series resistance which is schematically illustrated as resistor R_{Drain,sensor} in FIG. 8. The equivalent resistance in series with the n+p+ junction 700 provides an even more robust voltage blocking protection scheme for the voltage tap region 226 of the depletion mode sense transistor Q2. The n+p+ junction 700 limits the voltage at the substrate frontside at some level if the depletion mode sense transistor Q2 does not function as designed. A voltage between the frontside and the backside of the semiconductor substrate 202 results in some leakage current, which is limited by the equivalent series resistance. When the n+p+ junction 700 is small enough to limit the voltage to a safe level, a faulty depletion mode sense transistor Q2 can be detected and the power semiconductor device 102 can be safely turned off before device failure (e.g., shorting) occurs.

Although the present disclosure is not so limited, the following numbered examples demonstrate one or more aspects of the disclosure.

Example 1. A power semiconductor device, comprising: a semiconductor substrate; a power transistor formed in a cell field of the semiconductor substrate; a reference terminal; a sense terminal; and a depletion mode sense transistor integrated in the semiconductor substrate and having a voltage tap region of a first conductivity type, wherein the voltage tap region is electrically connected to the sense terminal and follows a drift zone potential of the power transistor until a normally conducting channel of the depletion mode sense transistor pinches off, wherein a pinch-off point of the normally conducting channel of the depletion mode sense transistor is designed such that a voltage between the sense terminal and the reference terminal is clamped below a maximum drain/collector voltage of the power semiconductor device.

Example 2. The power semiconductor device of example 1, wherein the pinch-off point of the normally conducting channel of the depletion mode sense transistor is designed such that the voltage between the sense terminal and the reference terminal is clamped in a range of 5V to 40V.

Example 3. The power semiconductor device of example 1 or 2, wherein the voltage tap region of the depletion mode sense transistor adjoins a drift zone of the first conductivity type shared with the power transistor or is part of the drift zone.

Example 4. The power semiconductor device of example 3, wherein the voltage tap region includes a doped region of the first conductivity type having a higher average doping concentration than the drift zone.

Example 5. The power semiconductor device of example 3 or 4, wherein the depletion mode sense transistor is a vertical device, wherein a gate trench of the depletion mode sense transistor extends from a first main surface of the semiconductor substrate into the semiconductor substrate, and wherein the voltage tap region adjoins a first sidewall of the gate trench at an upper part of the gate trench.

Example 6. The power semiconductor device of example 5, wherein a gate electrode in the gate trench is electrically connected to a source/emitter potential of the power transistor.

Example 7. The power semiconductor device of example 5 or 6, further comprising: a doped region of a second conductivity type opposite the first conductivity type adjoining a second sidewall of the gate trench opposite the first sidewall at the upper part of the gate trench.

Example 8. The power semiconductor device of example 7, wherein the semiconductor substrate is a SiC substrate, the power semiconductor device further comprising: a shielding region of the second conductivity type adjoining a bottom of the gate trench.

Example 9. The power semiconductor device of example 8, wherein the shielding region extends along the second sidewall of the gate trench to the doped region of the second conductivity type.

Example 10. The power semiconductor device of any of examples 7 through 9, wherein the doped region of the second conductivity type is electrically connected to a source/emitter potential of the power transistor.

Example 11. The power semiconductor device of any of examples 5 through 10, further comprising: a shielding trench extending from the first main surface of the semiconductor substrate into the semiconductor substrate, wherein the shielding trench is laterally interposed between the gate trench of the depletion mode sense transistor and a gate trench of the power transistor.

Example 12. The power semiconductor device of example 11, wherein an electrode in the shielding trench is electrically connected to a source/emitter potential of the power transistor.

Example 13. The power semiconductor device of example 11 or 12, further comprising: a doped region of a second conductivity type opposite the first conductivity type adjoining a first sidewall of the shielding trench, wherein the first sidewall of the shielding trench and the first sidewall of the gate trench of the depletion mode sense transistor face one another, and wherein the voltage tap region and the doped region of the second conductivity type are laterally spaced apart from one another by part of the drift zone.

Example 14. The power semiconductor device of example 13, wherein the semiconductor substrate is a SiC substrate, the power semiconductor device further comprising: a shielding region of the second conductivity type adjoining a bottom of the shielding trench.

Example 15. The power semiconductor device of example 14, wherein the shielding region extends along the first sidewall of the shielding trench to the doped region of the second conductivity type.

Example 16. The power semiconductor device of any of examples 11 through 15, wherein the doped region of the second conductivity type is electrically connected to a source/emitter potential of the power transistor.

Example 17. The power semiconductor device of example 3 or 4, wherein a gate electrode of the depletion mode sense transistor is disposed above and electrically insulated from a first main surface of the semiconductor substrate, the power semiconductor device further comprising: a doped body region of a second conductivity type opposite the first conductivity type extending under the gate electrode of the depletion mode sense transistor, wherein the voltage tap region is laterally spaced apart from the doped body region of the second conductivity type by part of the drift zone.

Example 18. The power semiconductor device of example 17, wherein the doped body region of the second conductivity type is electrically connected to a source/emitter potential of the power transistor.

Example 19. The power semiconductor device of example 17 or 18, wherein a lateral spacing between adjacent doped body regions of the depletion mode sense transistor is smaller than a vertical thickness of each doped body region.

Example 20. The power semiconductor device of any of examples 3 through 19, wherein the depletion mode sense transistor is a vertical device, wherein gate trenches of the depletion mode sense transistor extend from a first main surface of the semiconductor substrate into the semiconductor substrate, and wherein the depletion mode sense transistor further includes a more highly doped region of the first conductivity type in a part of the drift zone between adjacent ones of the gate trenches of the depletion mode sense transistor.

Example 21. The power semiconductor device of any of examples 3 through 19, wherein the depletion mode sense transistor is a vertical device, and wherein at least a part of the drift zone located laterally between a gate trench of the depletion mode sense transistor and a neighboring shielding region of a cell of the power transistor or a neighboring shielding trench includes a more highly doped region of the first conductivity type.

Example 22. The power semiconductor device of example 1 or 2, wherein the depletion mode sense transistor is formed in an edge termination region of the semiconductor substrate that separates the cell field from an edge of the semiconductor substrate, wherein the depletion mode sense transistor further comprises: an upper gate region of a second conductivity type opposite the first conductivity type; and a lower gate region of the second conductivity type, wherein the upper and lower gate regions are vertically separated from one another by a layer of the first conductivity type which includes the normally conducting channel, wherein the voltage tap region adjoins or is part of the layer of the first conductivity type.

Example 23. The power semiconductor device of example 22, further comprising: a doped region of the second conductivity type vertically extending to the lower gate region, wherein the doped region of the second conductivity type is electrically connected to a source/emitter potential of the power transistor, wherein the voltage tap region is laterally spaced apart from the doped region of the second conductivity type by part of the layer of the first conductivity type.

Example 24. The power semiconductor device of example 22 or 23, wherein at least a part of the layer of the first conductivity type located vertically between the upper and lower gate regions of the depletion mode sense transistor includes a more highly doped region of the first conductivity type.

Example 25. The power semiconductor device of any of examples 1 through 21, wherein the depletion mode sense transistor is a depletion mode HEMT (high-electron mobility transistor), wherein the normally conducting channel comprises a two-dimensional electron or hole gas in a heterojunction structure of the semiconductor substrate, and wherein the two-dimensional electron or hole gas is uninterrupted between a drain/collector region of the depletion mode HEMT and the voltage tap region absent a negative voltage applied between a gate of the depletion mode HEMT and the voltage tap region.

Example 26. The power semiconductor device of any of examples 1-12, 16, 20-21, and 25, further comprising: a gate trench, of the depletion mode sense transistor, extending from a first main surface of the semiconductor substrate into the semiconductor substrate; a shielding trench extending from the first main surface of the semiconductor substrate into the semiconductor substrate; and a doped region of a second conductivity type opposite the first conductivity type adjoining a first sidewall of the shielding trench at an upper part of the shielding trench, wherein the voltage tap region adjoins a first sidewall of the gate trench at an upper part of the gate trench, wherein the first sidewall of the shielding trench and the first sidewall of the gate trench face one another, wherein the voltage tap region and the doped region of the second conductivity type contact one another to form an n+p+ junction.

Example 27. The power semiconductor device of example 26, wherein the n+p+ junction has a blocking voltage in a range of a positive gate voltage of the depletion mode sense transistor.

Example 28. The power semiconductor device of example 26 or 27, wherein the n+p+ junction has a blocking voltage in a range of 15V to 40V.

Example 29. The power semiconductor device of any of examples 1-12, 16 and 25, further comprising: a gate electrode, of the depletion mode sense transistor, disposed above and electrically insulated from a first main surface of the semiconductor substrate; and a doped body region of a second conductivity type opposite the first conductivity type extending under the gate electrode of the depletion mode sense transistor, wherein the voltage tap region and the doped body region contact one another to form an n+p+ junction.

Example 30. The power semiconductor device of example 29, wherein the n+p+ junction has a blocking voltage in a range of a positive gate voltage of the depletion mode sense transistor.

Example 31. The power semiconductor device of example 29 or 30, wherein the n+p+ junction has a blocking voltage in a range of 15V to 40V.

Example 32. The power semiconductor device of any of examples 29 through 31, wherein the doped body region includes a more highly doped region of the second conductivity type abutting the voltage tap region.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

The expression "and/or" should be interpreted to cover all possible conjunctive and disjunctive combinations, unless expressly noted otherwise. For example, the expression "A and/or B" should be interpreted to mean A but not B, B but not A, or both A and B. The expression "at least one of" should be interpreted in the same manner as "and/or", unless expressly noted otherwise. For example, the expression "at least one of A and B" should be interpreted to mean A but not B, B but not A, or both A and B.

It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A power semiconductor device (102), comprising:
a semiconductor substrate (202);
a power transistor (Q1) formed in a cell field (200) of the semiconductor substrate (202);
a reference terminal;
a sense terminal; and
a depletion mode sense transistor (Q2) integrated in the semiconductor substrate (202) and having a voltage tap region (226) of a first conductivity type,
wherein the voltage tap region (226) is electrically connected to the sense terminal and follows a drift zone potential of the power transistor (Q1) until a normally conducting channel of the depletion mode sense transistor (Q2) pinches off,
wherein a pinch-off point of the normally conducting channel of the depletion mode sense transistor (Q2) is designed such that a voltage between the sense terminal and the reference terminal is clamped below a maximum drain/collector voltage of the power semiconductor device (102).

2. The power semiconductor device (102) of claim 1, wherein the pinch-off point of the normally conducting channel of the depletion mode sense transistor (Q2) is designed such that the voltage between the sense terminal and the reference terminal is clamped in a range of 5V to 40V.

3. The power semiconductor device (102) of claim 1, wherein the voltage tap region (226) of the depletion mode sense transistor (Q2) adjoins a drift zone (218) of the first conductivity type shared with the power transistor (Q1) or is part of the drift zone (218).

4. The power semiconductor device (102) of claim 3, wherein the voltage tap region (226) includes a doped region (228, 229, 236, 306, 510) of the first conductivity type having a higher average doping concentration than the drift zone (218).

5. The power semiconductor device (102) of claim 3, wherein the depletion mode sense transistor (Q2) is a vertical device, wherein a gate trench (208, 230) of the depletion mode sense transistor (Q2) extends from a first main surface (204, 206) of the semiconductor substrate (202) into the semiconductor substrate (202), and wherein the voltage tap region adjoins a first sidewall (238, 308) of the gate trench (208, 230) at an upper part of the gate trench (208, 230).

6. The power semiconductor device (102) of claim 5, wherein a gate electrode (210, 232) in the gate trench (208, 230) is electrically connected to a source/emitter potential of the power transistor (Q1).

7. The power semiconductor device (102) of claim 6, wherein the semiconductor substrate (202) is a SiC substrate, the power semiconductor device (102) further comprising:
a shielding region (242, 310) of the second conductivity type adjoining a bottom of the gate trench (208, 230).

8. The power semiconductor device (102) of claim 7, wherein the shielding region (242, 310) extends along the second sidewall (240) of the gate trench (208, 230) to the doped region (228, 229, 236, 306, 510) of the second conductivity type.

9. The power semiconductor device (102) of any of claims 5 to 8, further comprising:
a shielding trench (300) extending from the first main surface (204, 206) of the semiconductor substrate (202) into the semiconductor substrate (202),
wherein the shielding trench (300) is laterally interposed between the gate trench (208, 230) of the depletion mode sense transistor (Q2) and a gate trench (208, 230) of the power transistor (Q1).

10. The power semiconductor device (102) of claim 3, wherein a gate electrode (210, 232) of the depletion mode sense transistor (Q2) is disposed above and electrically insulated from a first main surface (204, 206) of the semiconductor substrate (202), the power semiconductor device (102) further comprising:
a doped body region (400) of a second conductivity type opposite the first conductivity type extending under the gate electrode (210, 232) of the depletion mode sense transistor (Q2),
wherein the voltage tap region (226) is laterally spaced apart from the doped body region (400) of the second conductivity type by part of the drift zone (218).

11. The power semiconductor device (102) of claim 3, wherein the depletion mode sense transistor (Q2) is a vertical device, and wherein at least a part of the drift zone (218) located laterally between a gate trench (208, 230) of the depletion mode sense transistor (Q2) and a neighboring shielding region (310) of a cell of the power transistor (Q1) or a neighboring shielding trench (300) includes a more highly doped region (228, 229, 236, 306, 510) of the first conductivity type.

12. The power semiconductor device (102) of claim 1, wherein the depletion mode sense transistor (Q2) is formed in an edge (502) termination region of the semiconductor substrate (202) that separates the cell field (200) from an edge (502) of the semiconductor substrate (202), wherein the depletion mode sense transistor (Q2) further comprises:
an upper gate region (504) of a second conductivity type opposite the first conductivity type; and
a lower gate (610) region of the second conductivity type,
wherein the upper and lower gate (610) regions are vertically separated from one another by a layer (508) of the first conductivity type which includes the normally conducting channel,
wherein the voltage tap region adjoins or is part of the layer (508) of the first conductivity type.

13. The power semiconductor device (102) of claim 1, wherein the depletion mode sense transistor (Q2) is a depletion mode HEMT (high-electron mobility transistor), wherein the normally conducting channel comprises a two-dimensional electron or hole gas in a heterojunction structure of the semiconductor substrate (202), and wherein the two-dimensional electron or hole gas is uninterrupted between a drain/collector region (220, 608) of the depletion mode HEMT and the voltage tap region (226) absent a negative voltage applied between a gate (610) of the depletion mode HEMT and the voltage tap region (226).

14. The power semiconductor device (102) of claim 1, further comprising:
a gate trench (208, 230), of the depletion mode sense transistor (Q2), extending from a first main surface (204, 206) of the semiconductor substrate (202) into the semiconductor substrate (202);
a shielding trench (300) extending from the first main surface (204, 206) of the semiconductor substrate (202) into the semiconductor substrate (202); and
a doped region (228, 229, 236, 306, 510) of a second conductivity type opposite the first conductivity type adjoining a first sidewall (238, 308) of the shielding trench (300) at an upper part of the shielding trench (300),
wherein the voltage tap region adjoins a first sidewall (238, 308) of the gate trench (208, 230) at an upper part of the gate trench (208, 230),
wherein the first sidewall (238, 308) of the shielding trench (300) and the first sidewall (238, 308) of the gate trench face one another,
wherein the voltage tap region (226) and the doped region (228, 229, 236, 306, 510) of the second conductivity type contact one another to form an n+p+ junction.

15. The power semiconductor device (102) of claim 1, further comprising:
a gate electrode (210, 232), of the depletion mode sense transistor (Q2), disposed above and electrically insulated from a first main surface (204, 206) of the semiconductor substrate (202); and
a doped body region (400) of a second conductivity type opposite the first conductivity type extending under the gate electrode (210, 232) of the depletion mode sense transistor (Q2),
wherein the voltage tap region (226) and the doped body region contact one another to form an n+p+ junction.

16. The power semiconductor device (102) of claim 14 or 15, wherein the n+p+ junction has a blocking voltage in a range of a positive gate voltage of the depletion mode sense transistor (Q2).
